(19) Europäisches Patentamt
European Patent Office
Office européen des brevets

(11) Veröffentlichungsnummer: **0 078 980**
**B1**

# (12) EUROPÄISCHE PATENTSCHRIFT

(45) Veröffentlichungstag der Patentschrift: **08.01.86**

(21) Anmeldenummer: **82109910.8**

(22) Anmeldetag: **27.10.82**

(51) Int. Cl.⁴: **G 03 C 1/52,** G 03 B 1/56, G 03 C 1/60, G 03 C 1/727, G 03 C 1/49 // G03F7/26, G03F7/08

## (54) Lichtempfindliches Gemisch und daraus hergestelltes lichtempfindliches Kopiermaterial.

(30) Priorität: **09.11.81 DE 3144480**

(43) Veröffentlichungstag der Anmeldung: **18.05.83 Patentblatt 83/20**

(45) Bekanntmachung des Hinweises auf die Patenterteilung: **08.01.86 Patentblatt 86/2**

(84) Benannte Vertragsstaaten: **AT BE CH DE FR GB LI NL**

(56) Entgegenhaltungen:
**DE - A - 2 331 377**
**DE - A - 2 641 100**
**DE - A - 2 718 259**
**DE - A - 2 928 636**
**DE - A - 2 944 237**

**Die Akte enthält technische Angaben, die nach dem Eingang der Anmeldung eingereicht wurden und die nicht in dieser Patentschrift enthalten sind.**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul Dr., Leibnizstrasse 18/B, D-6200 Wiesbaden (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 078 980 B1

**Beschreibung**

Die Erfindung betrifft ein lichtempfindliches, durch Belichten löslich werdendes Gemisch aus

a) einem 1,2-Chinondiazid oder einer Verbindung mit mindestens einer durch Säure spaltbaren C--O-C-Bindung,
b) einem wasserunlöslichen, in wässrig-alkalischen Lösungen löslichen Bindemittel,
c) einer photolytisch spaltbaren organischen Halogenverbindung und
d) einem Farbstoff,

das nach der Belichtung einen deutlich sichtbaren Farbkontrast zwischen belichteten und unbelichteten Bereichen aufweist.

Gemische der angegebenen Gattung werden vorzugsweise zur Herstellung von Flachdruckplatten und Photoresists verwendet und sind z.B. aus der DE-OS 2 331 377 bekannt. Die dort beschriebenen Gemische enthalten als Farbstoff (d) einen Triphenylmethan-, Azin- oder Anthrachinonfarbstoff und als organische Halogenverbindung (c) ein 1,2--Naphthochinon-2-diazid-4-sulfonsäurehalogenid. Sie ergeben nach der Bildbelichtung einen Bildkontrast, der bei Tageslicht oder bei weissem Kunstlicht gut sichtbar ist. Er ist jedoch unter gelbem Sicherheitslicht, wie es beim Arbeiten mit reprographischen Materialien gewöhnlich verwendet wird, weniger ausgeprägt und in manchen Fällen nicht ausreichend.

In der DE-OS 2 229 365 werden entsprechende Gemische beschrieben, die als Farbstoffe bestimmte Azofarbstoffe und als Säurespender Diazoniumsalze starker Säuren enthalten. Diese Gemische ergeben bei Normallicht und bei Sicherheitslicht nur einen verhältnismässig geringen visuellen Kontrast.

In den DE-OS 2 641 099 und 2 843 069 sind ähnliche Gemische beschrieben, die als Säurespender Diazoniumsalze und als Farbstoffe Azo-, Triphenylmethan-, Azin- oder Anthrachinonfarbstoffe enthalten. Auch ihr Kontrast ist bei gelbem Sicherheitslicht häufig nicht ausreichend.

In der DE-OS 2 641 100 sind entsprechende Gemische beschrieben, die als Säurespender Trihalogenmethyl-s-triazine oder Trihalogenmethyl-2-pyrone und als Farbstoffe Azin-, Triphenylmethan- oder Anthrachinonfarbstoffe enthalten. Ihr Verhalten ist ähnlich wie das der vorstehend genannten Gemische.

Der Erfindung liegt die Aufgabe zugrunde, ein positiv arbeitendes lichtempfindliches Gemisch der eingangs beschriebenen Gattung zur Verfügung zu stellen, das nach bildmässigem Belichten ein kontrastreiches Abbild der Vorlage zeigt, das auch unter gelbem Sicherheitslicht gut zu erkennen ist.

Gegenstand der Erfindung ist ein lichtempfindliches Gemisch aus

a) einem 1,2-Chinondiazid oder einer Verbindung mit mindestens einer durch Säure spaltbaren C--O-C-Bindung,
b) einem wasserunlöslichen, in wässrig-alkalischen Lösungen löslichen Bindemittel,
c) einer photolytisch spaltbaren organischen Halogenverbindung

entsprechend einer der allgemeinen Formeln I und II

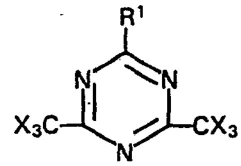

I

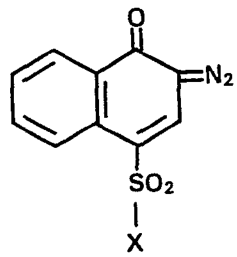

II

worin

$R^1$ einen direkt oder über eine konjugierte Kette gebundenen aromatischen Rest und
X ein Halogenatom bedeuten, und

d) einem Farbstoff.

Das erfindungsgemässe Gemisch ist dadurch gekennzeichnet, dass der Farbstoff ein blauer Azofarbstoff mit mindestens einer Nitrogruppe im Molekül ist.

Die in dem Gemisch enthaltenen Azofarbstoffe enthalten mindestens eine, bevorzugt 2 oder mehrere Nitrogruppen im Molekül. Bevorzugt werden Monoazofarbstoffe, insbesondere solche aus substituierten Benzoldiazoniumverbindungen und aromatischen Aminen, als Kupplungskomponenten. Die Azofarbstoffe können ausser Nitrogruppen weitere Substituenten enthalten. Beispiele für bevorzugte Substituenten sind: Aminogruppen, besonders tertiäre Aminogruppen, Halogenatome, Alkoxygruppen und Acylaminogruppen. Gerade bei blauen Azofarbstoffen ergibt sich ein besonders günstiger Farbkontrast. Die Menge des Azofarbstoffs beträgt im allgemeinen 0,5 bis 10, vorzugsweise 2 bis 7 Gew.-%, bezogen auf die nichtflüchtigen Bestandteile des Gemischs.

Azofarbstoffe, die ein Reaktionsprodukt aus 2,4--Dinitro-6-chlor-benzoldiazoniumsalz mit 2-Methoxy-5-acetylamino-N,N-diethylanilin, 2-Methoxy-5--acetylamino-N-cyanoethyl-N-hydroxyethyl-anilin oder 2-Ethoxy-5-acetylamino-N,N-bis(acetoxyethyl)-anilin darstellen, haben sich besonders bewährt.

Die organischen Halogenverbindungen, die als Säurespender verwendet werden, sind s-Triazinderivate oder Naphthochinondiazidsulfonylhalogenide der oben angegebenen Formeln. Diese Verbindungen sind als Säurespender in lichtempfindlichen Gemischen an sich bekannt und in den DE-OS 2 331 377, 2 243 621 und 2 718 259 beschrieben. Von den Naphthochinondiazidsulfonylhalogeniden werden die Fluoride, Chloride und Bromide, insbesondere die Chloride bevorzugt. Von den s-Triazinderivaten der Formel I werden solche bevor-

zugt, in den der Rest $R^1$ ein ggf. substituierter Naphthyl-, Acenaphthyl-, Diphenylyl- oder Styrylrest ist. Geeignete Substituenten sind in den genannten Druckschriften beschrieben. Die Halogenverbindungen werden im allgemeinen in Mengen von 1 bis 20, vorzugsweise von 5 bis 12 Gew.-%, bezogen auf die nichtflüchtigen Bestandteile, zugesetzt.

Die erfindungsgemässen Gemische sind in Form lichtempfindlicher, auf einen Schichtträger aufgebrachter Schichten oder als Lösungen für die Herstellung von Photoresistschichten über längere Zeiträume im Dunkeln ohne Zersetzung lagerfähig. Der mit ihnen erreichte Bildkontrast ist wesentlich brillanter, als er mit den gleichen Säurespendern in Kombination mit Triphenylmethan-, Azin- oder Anthrachinonfarbstoffen oder mit Azofarbstoffen erzielt wird, die keine Nitrogruppen enthalten.

Das erfindungsgemässe Gemisch enthält als weiteren wesentlichen Bestandteil eine lichtempfindliche Verbindung (a), die mindestens ein 1,2-Chinondiazid oder eine Verbindung mit mindestens einer durch Säure spaltbaren C-O-C-Bindung darstellt und deren Löslichkeit in einer wässrig-alkalischen Entwicklerlösung beim Belichten erhöht wird.

Als o-Chinondiazide werden bevorzugt Naphthochinon-(1,2)-diazid-(2)-4- oder -5-sulfonsäureester oder -amide verwendet. Von diesen werden die Ester, insbesondere die der 5-Sulfonsäuren, besonders bevorzugt. Geeignete Verbindungen dieser Art sind bekannt und z.B. in der DE-PS 938 233, den DE-OS 2 331 377, 2 547 905 und 2 828 037 beschrieben.

Die Menge an diesen o-Chinondiazidverbindungen beträgt im allgemeinen 3 bis 50, bevorzugt 7 bis 35 Gew.-%, bezogen auf die nichtflüchtigen Anteile des Gemischs.

Auch Materialien auf Basis säurespaltbarer Verbindungen lassen sich mit gutem Effekt in dem erfindungsgemässen Gemisch einsetzen.

Kopiermaterialien dieser Art sind bekannt und z.B. in den US-PS 3 779 778 und 4 101 323, der DE-PS 2 718 254 und den DE-OS 2 829 512, 2 829 511 und 2 928 636 beschrieben. Sie enthalten als säurespaltbare Verbindungen Orthocarbonsäurederivate, monomere oder polymere Acetale, Enolether oder Acyliminocarbonate, wobei die Orthocarbonsäurederivate und Acetale bevorzugt werden. Als strahlungsempfindliche, Säure abspaltende Verbindungen enthalten sie vorwiegend organische Halogenverbindungen, insbesondere durch Halogenmethylgruppen substituierte s-Triazine.

Von den in der US-PS 4 101 323 beschriebenen Orthocarbonsäurederivaten werden insbesondere die Diphenoxymethylether aliphatischer oder aromatischer Hydroxyverbindungen, die N-Diphenoxymethylderivate von Lactamen sowie ganz besonders die Bis-1,3-dioxan-2-yl-ether von aliphatischen Diolen verwendet.

Von den in der DE-PS 2 718 254 beschriebenen Polyacetalen werden diejenigen mit aliphatischen Aldehyd- und Dioleinheiten bevorzugt.

Von den in der DE-OS 2 928 636 beschriebenen polymeren Orthoestern werden Polymere mit wiederkehrenden 1,3-Dioxa-cyclohex-2-yl-alkylethereinheiten besonders bevorzugt, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 60, vorzugsweise zwischen 14 und 40 Gew.-%, bezogen auf die nichtflüchtigen Bestandteile des Gemischs. Die Menge der damit kombinierten Säure abspaltenden Verbindung liegt zwischen 0,1 und 10, vorzugsweise zwischen 0,2 und 5 Gew.-%.

Die erfindungsgemässen lichtempfindlichen Gemische enthalten ferner ein polymeres, wasserunlösliches harzartiges Bindemittel, das sich in den für das erfindungsgemässe Gemisch verwendeten Lösungsmitteln löst und in wässrigen Alkalien ebenfalls löslich ist.

Die bei vielen Positiv-Kopiermaterialien auf Basis von Naphthochinondiaziden bewährten Novolak-Kondensationsharze haben sich als Zusatz auch bei den erfindungsgemässen Gemischen als besonders brauchbar und vorteilhaft erwiesen. Sie fördern die starke Differenzierung zwischen den belichteten und unbelichteten Schichtpartien beim Entwickeln, besonders die höher kondensierten Härze mit substituierten Phenolen, z.B. Kresolen, als Formaldehyd-Kondensationspartner. Als weitere alkalilösliche bzw. in Alkali quellbare Bindemittel sind natürliche Harze, wie Schellack und Kolophonium, und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein; bevorzugt werden Anteile am Gesamtfeststoff zwischen 95 und 35, besonders bevorzugt 90 - 55 Gew.-%. Zusätzlich können noch zahlreiche andere Harze mitverwendet werden, bevorzugt Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluss auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz und Färbung, ausserdem noch Substanzen, wie Polyglykole, Cellulose-derivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether, werden besonders bevorzugt.

Als Schichtträger für Schichtdicken unter ca. 10 µm werden meist Metalle verwendet. Für Offsetdruckplatten können eingesetzt werden: walzblankes, mechanisch oder elektromechanisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolysiertem Tetraethylorthosilikat, vorbehandelt sein kann, ausserdem Mehrmetallplatten z.B. aus Al/Cu/Cr oder aus Messing/Chrom. Für die Herstellung von Hochdruckplatten können die erfindungsgemässen Gemische auf Zink- oder Magnesium-Platten sowie deren handelsübliche mikrokristalline Legierungen für Einstufenätzverfahren aufgetragen werden, ausserdem auf ätzbare Kunststoffe wie Polyoxymethylen. Für Tiefdruck- oder Siebdruckformen eignen sich die erfindungsgemässen Gemische durch ihre gute Haftung und Ätzfestigkeit auf Kupfer- und Nickeloberflächen. Ebenso lassen sich die erfindungsgemässen Gemische als Photoresists in der Leiterplattenfertigung und beim Formteilätzen verwenden. Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transferschichten dienen. Dafür werden Polyesterfolien, z.B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Giesser-Antrag. Schliesslich kann die Beschichtung von z.B. Leiterplatten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Lasern stellt eine Möglichkeit zur Belichtung dar.

Die zum Entwickeln verwendeten wässrig-alkalischen Lösungen abgestufter Alkalität, vorzugsweise mit einem pH im Bereich von 10-14, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemässen lichtempfindlichen Gemische bei der Herstellung von Druckformen, d.h. insbesondere Offset-, autotypischen Tiefdruck- und Siebdruckformen, in Photoresistlösungen und sogenannten Trokkenresists.

Die Erfindung wird anhand der folgenden Beispiele näher erläutert, in denen Gewichtsteile (Gt) und Volumenteile (Vt) im Verhältnis von g zu ccm stehen. Prozente sind, wenn nichts anderes angegeben ist, Gewichtsprozente.

*Beispiel 1*

Mit einer Lösung von

| | |
|---|---|
| 0,70 Gt | des Veresterungsproduktes aus 1 Mol 2,3,4-Trihydroxy-benzophenon und 2 Mol Naphthochinon-(1,2)-diazid-(2)-5-sulfonsäurechlorid, |
| 0,40 Gt | des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid, |
| 6,00 Gt | eines Kresol-Formaldehyd-Novolaks mit einem Erweichungspunkt von 120 bis 135°C und einem durchschnittlichen Molgewicht von 1500, |
| 0,80 Gt | Naphthochinon-(1,2)-diazid-(2)-4-sulfonsäurechlorid und |
| 0,40 Gt | eines blauen Azofarbstoffes, erhalten durch Kuppeln von 2,4-Dinitro-6-chlor-benzoldiazoniumsalz mit 2-Methoxy-5-acetylamino-N,N-diethylanilin, in |
| 40 Gt | Ethylenglykolmonomethylether und |
| 50 Gt | Tetrahydrofuran |

wurde eine elektrochemisch aufgerauhte und anodisierte Aluminiumplatte beschichtet. Der anodisierte Träger war vor dem Aufbringen der lichtempfindlichen Schicht mit einer wässrigen Lösung von Polyvinylphosphonsäure behandelt worden. Die so hergestellte vorsensibilisierte Druckplatte mit einem Schichtgewicht von 2,30 g/m$^2$ wurde unter einer transparenten Positivvorlage bildmässig belichtet.

Während die unbelichteten Bereiche der Kopierschicht tief dunkelblau gefärbt blieben, schlug die Farbe der belichteten Bereiche der Schicht nach gelb bis hellbraun um. Das Bild der Vorlage war auch bei gelber Beleuchtung in allen Einzelheiten deutlich erkennbar.

Zur Herstellung der Druckform wurde die belichtete Druckplatte in bekannter Weise mit einer 7,3%igen wässrigen Natriummetasilikatlösung entwickelt, wobei die belichteten Bereiche entfernt wurden. Die zurückbleibenden, nicht belichteten Schichtbereiche blieben mit gutem Kontrast zum ungefärbten Untergrund sichtbar.

In den folgenden Beispielen 2 bis 6 wurde in entsprechender Weise wie im obigen Beispiel 1 verfahren, und es wurden nach dem Belichten der erhaltenen lichtempfindlichen Druckplatten hinsichtlich Bildkontrast — sowohl vor als auch nach dem Entwickeln — im wesentlichen entsprechende gute Resultate erhalten. Es werden daher für die folgenden Beispiele meist nur die Rezepturen der Beschichtungslösungen und die Art der verwendeten Schichtträger angegeben und nur gelegentlich weitere kurze Bemerkungen hinzugefügt.

*Beispiel 2*

Beschichtungslösung:

| | |
|---|---|
| 1,0 Gt | des Veresterungsproduktes aus 1 Mol 2,3,4-Trihydroxybenzophenon und 3 Mol Naphthochinon-(1,2)-diazid-(2)-5-sulfonsäurechlorid, |
| 6,0 Gt | eines Phenol-Formaldehyd-Novolaks mit einem Erweichungspunkt von 110 bis 120°C; |

0,8 Gt 2-(4-Ethoxy-naphth-1-yl)-4,6-bis-trichlormethyl-s-triazin,
0,4 Gt des in Beispiel 1 angegebenen Azofarbstoffes,
40,0 Gt Ethylenglykolmonomethylether,
50,0 Gt Tetrahydrofuran.

Kopierschichtträger: Elektrochemisch aufgerauhte und anodisierte Aluminiumplatte entsprechend Beispiel 1.

Farbumschlag der belichteten Bereiche von tief dunkelblau nach hell gelbbraun.

*Beispiel 3*

Beschichtungslösung:

1,0 Gt des Veresterungsproduktes aus 1 Mol 2,3,4-Trihydroxybenzophenon und 3 Mol Naphthochinon-(1,2)-diazid-(2)-5-sulfonsäurechlorid,
6,2 Gt des in Beispiel 1 angegebenen Novolaks,
0,8 Gt Naphthochinon-(1,2)-diazid-(2)-4-sulfonsäurechlorid,
0,3 Gt eines blauen Azofarbstoffes, erhalten durch Kuppeln von 2,4-Dinitro-6-chlor-benzoldiazoniumsalz mit 2-Methoxy-5-acetylamino-N-cyanoethyl-N-hydroxy-ethyl-anilin,
40,0 Gt Ethylenglykolmonomethylether,
50,0 Gt Tetrahydrofuran.

Schichtträger: Elektrochemisch aufgerauhte und anodisierte Aluminiumplatte entsprechend Beispiel 1.

Farbumschlag der belichteten Bereiche von tief dunkelblau nach gelbbraun.

*Beispiel 4*

Beschichtungslösung:

0,8 Gt des Veresterungsproduktes aus 1 Mol 2,3,4-Trihydroxybenzophenon und 2 Mol Naphthochinon-(1,2)-diazid-(2)-5-sulfonsäurechlorid,
0,5 Gt des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid,
6,0 Gt des in Beispiel 2 angegebenen Phenol-Formaldehyd-Novolaks,
0,7 Gt 2,4-Bis-trichlormethyl-6-p-methoxystyryl-s-triazin,
0,2 Gt eines blauen Farbstoffes, erhalten durch Kuppeln von 2,4-Dinitro-6-chlor-benzoldiazoniumsalz mit 2-Ethoxy-5-acetylamino-N,N-Bis-(acetoxyethyl)-anilin,
40,0 Gt Ethylenglykolmonomethylether,
50,0 Gt Tetrahydrofuran.

Schichtträger: Elektrochemisch aufgerauhte und anodisierte Aluminiumplatte entsprechend Beispiel 1.

Farbumschlag der belichteten Bereiche von dunkelblau nach gelbbraun.

*Beispiel 5*

Beschichtungslösung:

1,0 Gt des Veresterungsproduktes aus 1 Mol 2,3,4-Trihydroxybenzophenon und 3 Mol Naphthochinon-(1,2)-diazid-(2)-5-sulfonsäurechlorid,
6,0 Gt des in Beispiel 2 angegebenen Phenol-Formaldehyd-Novolaks,
0,9 Gt 2-(Acenaphth-5-yl)-4,6-bis-trichlormethyl-s-triazin,
0,4 Gt des in Beispiel 1 angegebenen Azofarbstoffes,
40,0 Gt Ethylenglykolmonomethylether,
50,0 Gt Tetrahydrofuran.

Schichtträger: Elektrochemisch aufgerauhte und anodisierte Aluminiumplatte entsprechend Beispiel 1.

Farbumschlag der belichteten Bereiche von tief dunkelblau nach hellbraun.

*Beispiel 6*

Beschichtungslösung:

1,2 Gt einer 50%igen Lösung eines Polyorthoesters in Toluol, hergestellt aus 7,7-Bis-hydroxymethyl-5-oxa-nonanol-(1) und Orthoameisensäuretrimethylester,
0,3 Gt Naphthochinon-(1,2)-diazid-(2)-4-sulfonsäurechlorid,
0,2 Gt des in Beispiel 1 angegebenen Kresol-Formaldehyd-Novolaks,
0,1 Gt des in Beispiel 1 angegebenen Azofarbstoffes,
20,0 Gt Ethylenglykolmonomethylether,
20,0 Gt Tetrahydrofuran.

Schichtträger: Elektrochemisch aufgerauhte und anodisierte Aluminiumplatte.

Farbumschlag der belichteten Bereiche von dunkelblau nach gelbbraun.

*Beispiel 7*

Beschichtungslösung:

0,6 Gt eines Polyacetals, hergestellt aus Triethylenglykol und 2-Ethyl-butyraldehyd,
0,2 Gt 2,4-Bis-trichlormethyl-6-(4-phenyl-phenyl)-s-triazin,
3,0 Gt des in Beispiel 1 angegebenen Novolaks,
0,1 Gt des in Beispiel 1 angegebenen Azofarbstoffes,
20,0 Gt Ethylenglykolmonomethylether,
30,0 Gt Tetrahydrofuran.

Schichtträger: Elektrochemisch aufgerauhte und anodisierte Aluminiumplatte.

Farbumschlag der belichteten Bereiche von dunkelblau nach hellbraun.

**Patentansprüche**

1. Lichtempfindliches Gemisch aus

a) mindestens einem 1,2-Chinondiazid oder einer Verbindung mit mindestens einer durch Säure spaltbaren C-O-C-Bindung,
b) einem wasserunlöslichen, in wässrig-alkalischen Lösungen löslichen Bindemittel,
c) einer photolytisch spaltbaren, säurebildenden organischen Halogenverbindung entsprechend einer der allgemeinen Formeln I und II

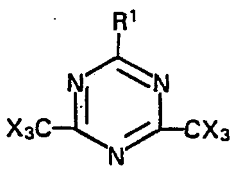

I

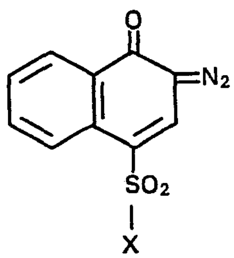

II

worin
$R^1$ einen direkt oder über eine konjugierte Kette gebundenen aromatischen Rest und
X ein Halogenatom bedeuten, und

d) einem Farbstoff,

dadurch gekennzeichnet, dass der Farbstoff ein blauer Azofarbstoff mit mindestens einer Nitrogruppe im Molekül ist.

2. Lichtempfindliches Gemisch nach Anspruch 1, dadurch gekennzeichnet, dass es einen Monoazofarbstoff enthält.

3. Lichtempfindliches Gemisch nach Anspruch 1, dadurch gekennzeichnet, dass der Azofarbstoff ein Reaktionsprodukt aus 2,4-Dinitro-6-chlor-benzoldiazoniumsalz mit 2-Methoxy-5-acetylamino-N-N-diethylanilin, 2-Methoxy-5-acetylamino-N-cyanoethyl-N-hydroxyethyl-anilin oder 2-Ethoxy-5-acetylamino-N,N-bis(acetoxyethyl)-anilin ist.

4. Lichtempfindliches Gemisch nach Anspruch 1, dadurch gekennzeichnet, dass es 0,5 bis 10 Gew.-% an Azofarbstoff, bezogen auf seinen Gehalt an nichtflüchtigen Bestandteilen, enthält.

5. Lichtempfindliches Gemisch nach Anspruch 1, dadurch gekennzeichnet, dass X ein Chlor- oder Bromatom ist.

6. Lichtempfindliches Gemisch nach Anspruch 1, dadurch gekennzeichnet, dass $R^1$ ein ggf. substituierter Naphthyl-, Acenaphthyl-, Diphenyl- oder Styrylrest ist.

7. Lichtempfindliches Gemisch nach Anspruch 1, dadurch gekennzeichnet, dass es als Bindemittel einen Novolak enthält.

8. Lichtempfindliches Gemisch nach Anspruch 1, dadurch gekennzeichnet, dass es als 1,2-Chinondiazid einen 1,2-Naphthochinon-2-diazid-sulfonsäureester enthält.

9. Lichtempfindliches Gemisch nach Anspruch 1, dadurch gekennzeichnet, dass es als Verbindung mit mindestens einer durch Säure spaltbaren C-O-C-Bindung ein Orthocarbonsäurederivat oder eine Verbindung mit mindestens einer Acetalgruppe im Molekül enthält.

10. Lichtempfindliches Kopiermaterial aus einem Schichtträger und einer lichtempfindlichen Schicht, die bei Belichtung in einem Entwickler löslich wird, und die als wesentliche Bestandteile

a) mindestens ein 1,2-Chinondiazid oder eine Verbindung mit mindestens einer durch Säure spaltbaren C-O-C-Bindung,
b) ein wasserunlösliches, in wässrig-alkalischen Lösungen lösliches Bindemittel,
c) eine photolytisch spaltbare, säurebildende organische Halogenverbindung entsprechend einer der allgemeinen Formeln

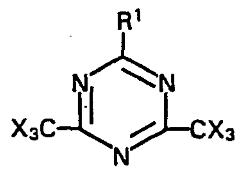

I

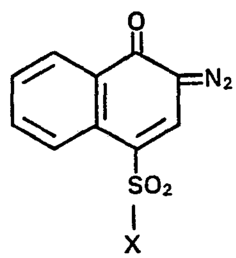

II

worin
$R^1$ einen direkt oder über eine konjugierte Kette gebundenen aromatischen Rest und
X ein Halogenatom bedeuten, und

d) einen Farbstoff

enthält, dadurch gekennzeichnet, dass der Farbstoff ein blauer Azofarbstoff mit mindestens einer Nitrogruppe im Molekül ist.

## Claims

1. A light-sensitive mixture of

a) at least one 1,2-quinonediazide or a compound having at least one C-O-C bond cleavable by acid,
b) a water-insoluble binder soluble in aqueous-alkaline solutions,
c) a photolytically cleavable, acid-forming organic halogen compound of one of the formulae I and II

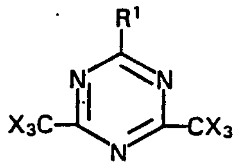

I

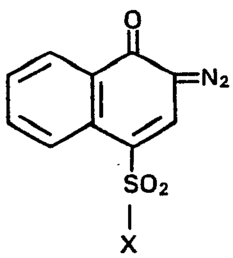

II

in which
$R^1$ denotes an aromatic radical bonded directly or via a conjugated chain and
X denotes a halogen atom, and

d) a dyestuff,

wherein the dyestuff is a blue azo dyestuff containing at least one nitro group in the molecule.

2. A light-sensitive mixture as claimed in claim 1, which contains a monoazo dyestuff.

3. A light-sensitive mixture as claimed in claim 1, wherein the azo dyestuff is a reaction produkt of 2,4-dinitro-6-chlorobenzene diazonium salt with 2-methoxy-5-acetylamino-N,N-diethylaniline, 2-methoxy-5-acetylamino-N-cyanoethyl-N-hydroxyethylaniline or 2-ethoxy-5-acetylamino-N,N-bis(acetoxyethyl)-aniline.

4. A light-sensitive mixture as claimed in claim 1, which contains 0.5 to 10% by weight of azo dyestuff, relative to its content of nonvolatile constituents.

5. A light-sensitive mixture as claimed in claim 1, wherein X is a chlorine or bromine atom.

6. A light-sensitive mixture as claimed in claim 1, wherein $R^1$ is an optionally substituted naphthyl, acenaphthyl, diphenylyl or styryl radical.

7. A light-sensitive mixture as claimed in claim 1, which contains a novolak as the binder.

8. A light-sensitive mixture as claimed in claim 1, which contains a 1,2-naphthoquinone-2-diazidesulfonic acid ester as the 1,2-quinonediazide.

9. A light-sensitive mixture as claimed in claim 1, which contains an orthocarboxylic acid derivative or a compound having at least one acetal group in the molecule as the compound having at least one C-O-C bond cleavable by acid.

10. A light-sensitive copying material comprised of a support and a light-sensitive layer which becomes soluble in a developer on exposure and contains, as essential constituents,

a) a 1,2-quinonediazide or a compound having at least one C-O-C bond cleavable by acid,
b) a water-insoluble binder soluble in aqueous-alkaline solutions,
c) a photolytically cleavable, acid-forming organic halogen compound of one of the formulae

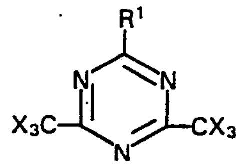

I

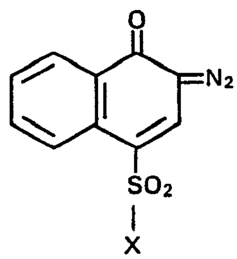

II

in which
$R^1$ denotes an aromatic radical bonded directly or via a conjugated chain and
X denotes a halogen atom, and

d) a dyestuff,

wherein the dyestuff is a blue azo dyestuff containing at least one nitro group in the molecule.

**Revendications**

1. Mélange photosensible constitué

a) d'au moins un 1,2-quinone-diazide ou d'un composé possédant au moins une liaison C-O-C pouvant être rompue par un acide,
b) d'un liant insoluble dans l'eau, soluble dans des solutions aqueuses alcalines,
c) d'un composé halogéné organique dissociable par photolyse, libérant un acide, correspondant à l'une des formules générales I et II

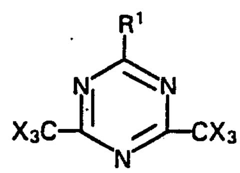

I

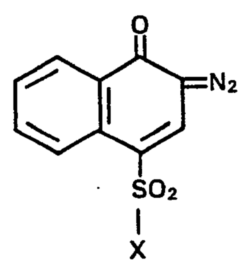

II

dans lesquelles
$R^1$ représente un radical aromatique fixé directement ou par l'intermédiaire d'une chaîne conjuguée et
X représente un halogène, et

d) d'un colorant,

caractérisé par le fait que le colorant est un colorant azoïque bleu contenant au moins un groupe nitro dans sa molécule.

2. Mélange photosensible selon la revendication 1, caractérisé par le fait qu'il contient un colorant monoazoïque.

3. Mélange photosensible selon la revendication 1, caractérisé par le fait que le colorant azoïque est un produit de réaction de sel de diazonium de 2,4-dinitro-6-chlorobenzène avec la 2-méthoxy-5-acétylamino-N,N-diéthylaniline, la 2-méthoxy-5-acétylamino-N-cyanoéthyl-N-hydroxyéthyl-aniline ou la 2-éthoxy-5-acétylamino-N,N-bis(acétoxyéthyl-aniline.

4. Mélange photosensible selon la revendication 1, caractérisé par le fait qu'il contient 0,5 à 10% en poids de colorant azoïque, rapporté à sa teneur en constituants non volatils.

5. Mélange photosensible selon la revendication 1, caractérisé par le fait que X est un atome de chlore ou de brome.

6. Mélange photosensible selon la revendication 1, caractérisé par le fait que $R^1$ est un radical naphtyle, acénaphtyle, diphénylyle ou styryle, éventuellement substitué.

7. Mélange photosensible selon la revendication 1, caractérisé par le fait qu'il contient en tant que liant une Novolaque.

8. Mélange photosensible selon la revendication 1, caractérisé par le fait qu'il contient en tant que 1,2-quinone-diazide un ester d'acide 1,2-naphtoquinone-2-diazide-sulfonique.

9. Mélange photosensible selon la revendication 1, caractérisé par le fait qu'il contient en tant que composé possédant au moins une liaison C-O-C pouvant être rompue par un acide un dérivé d'acide orthocarboxylique ou un composé contenant dans sa molécule au moins un groupe acétal.

10. Matériau de reproduction photosensible constitué d'un support de couche et d'une couche photosensible qui, à l'exploitation, devient soluble dans un révélateur, et qui contient comme constituants essentiels

a) au moins un 1,2-quinone-diazide ou un composé possédant au moins une liaison C-O-C pouvant être rompue par un acide,

b) un liant insoluble dans l'eau, soluble dans des solutions aqueuses alcalines,

c) d'un composé halogéné organique dissociable par photolyse, libérant un acide, correspondant à l'une des formules générales

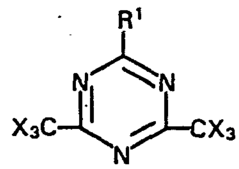

I

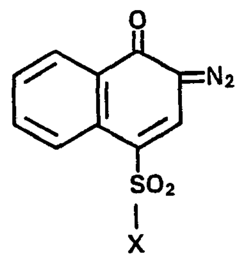

II

dans lesquelles

$R^1$ représente un radical aromatique fixé directement ou par une liaison conjuguée et

X représente un halogène, et

d) un colorant,

caractérisé par le fait que le colorant est un colorant azoïque bleu contenant au moins un groupe nitro dans sa molécule.